# EUROPEAN PATENT SPECIFICATION

(11) **EP 3 173 665 B1**
(45) Date of publication and mention of the grant of the patent: **13.03.2019**
(21) Application number: 15822736.3
(22) Date of filing: 10.06.2015
(51) Int. Cl.: F16H 25/20, F16H 57/04, F16H 25/24

(54) **ELECTRIC ACTUATOR**
ELEKTRISCHER AKTUATOR
ACTIONNEUR ÉLECTRIQUE

(30) Priority: 17.07.2014 JP 2014146596
(43) Date of publication of application: 31.05.2017
(73) Proprietor: SMC Corporation, Tokyo 101-0021 (JP)
(72) Inventor: NAKAYAMA, Toru, Tsukubamirai-shi, Ibaraki 300-2493 (JP); SUGIYAMA, Toru, Tsukubamirai-shi, Ibaraki 300-2493 (JP); MASUI, Ryuichi, Tsukubamirai-shi, Ibaraki 300-2493 (JP); OKUHIRA, Hiroyuki, Tsukubamirai-shi, Ibaraki 300-2493 (JP)
(74) Representative: Keil & Schaafhausen Patent- und Rechtsanwälte PartGmbB
(86) International application number: PCT/JP2015/066692
(87) International publication number: WO 2016/009750

(56) References cited:
- JP-A- H08 200 466
- JP-A- H08 200 466
- JP-A- H11 247 962
- JP-A- H11 247 962
- JP-A- 2003 294 102
- JP-A- 2003 294 102
- JP-A- 2005 282 708
- JP-A- 2005 282 708
- JP-A- 2007 247 534
- JP-A- 2008 051 335
- JP-A- 2008 051 335
- JP-A- 2012 159 124
- JP-A- 2012 159 124

## Description

### Technical Field

The present invention relates to an electric actuator including a sliding screw shaft and a nut that is screw-engaged with the sliding screw shaft, the sliding screw shaft being configured to rotate under operation of a motor to thereby cause the nut to be displaced in an axial direction of the sliding screw shaft.

### Background Art

An electric actuator includes a feed screw shaft that rotates by operation of a motor, and a nut that is screw-engaged with the feed screw shaft. As this feed screw shaft, in general, a ball screw shaft or a sliding screw shaft is used. In view of abrasion resistance, the ball screw shaft is made of quenched steel and the sliding screw shaft is made of iron, and nickel-plated or hard-chromium-plated. The nut screw-engaged with the sliding screw shaft is made of copper, resin, etc.

For example, Japanese Laid-Open Patent Publication No. 2014-047884 proposes a technical concept regarding an electric actuator having a ball screw shaft. In the actuator, a diamond-like carbon (DLC: Diamond-Like Carbon) film is formed on a rod seal member to decrease the friction coefficient between the rod and the rod seal member to ensure smooth operation, and improve abrasion resistance.

Document JP 2005 - 282708 A1 discloses a motor-driven linear actuator comprising an electric stepping motor and a feed screw device. A nut member made of metal such as gunmetal is threadedly engaged with a feed screw portion of a feed screw shaft. An output shaft of the motor is connected to the feed screw shaft. The feed screw portion is coated by a thin film forming method such as DLC.

In document JP 2008 - 051335 A, a carrier is engaged with a lead screw. The lead screw is formed on a rotary shaft. When the rotary shaft rotates, the carrier moves in an axial direction of the rotary shaft along the lead screw. In particular, the carrier slides on a flank surface of the lead screw. A base member of the rotating shaft is made of aluminium or an aluminium alloy. A base film such as a chromate film or an alumite film is formed on a surface of the base material and the resin film is formed by electrodeposition on its surface. Hence, the flank surface of the lead screw sliding on the carrier is covered with the resin film.

Document JP 2003 - 294102 A discloses a rotation introducing device comprising a cylindrical housing and an output shaft rotatably supported in the housing on one end side. A feed screw mechanism comprising a feed screw nut is installed on a screw shaft part. A lubricating film and hard layer are provided on the screw shaft part and the feed screw mechanism. The hard layer can be formed as a DLC layer.

Document JP H08 - 200466 A discloses a way to manufacture a high accurate small diametric high lead screw. In particular, a helical thread groove is formed in a hollow shaft, a wire rod is wound along the thread groove, and the thread groove and the wire rod are joint. A feed device of an office equipment comprises the high lead screw, a nut screwed to the high lead screw, and a servomotor connected to the high lead screw.

A feed screw mechanism according to document JP 2012 - 159124 A includes a feed screw shaft having a male screw part, and at member having a female screw part to be engaged with the main screw part of the feed screw shaft, a connection member that moves along the shaft centre of the feed screw shaft together with the nut member due to rotation of the feed screw shaft, a guide rod arranged parallel to the feed screw shaft, and a slider that moves along the shaft centre direction of the guide rod. The connection member includes a nut housing part that houses the nut member. An alignment mechanism part S is provided between an outer surface of the nut member and the inner surface of the nut housing part. Convex spherical surfaces of the nut member and concave spherical surfaces of the coupling member construct a low-friction member. The nut member has a low-friction layer formed on a surface of its metallic body, wherein the low-friction layer is made of a fluorine-based resin film or carbon resin film.

Document JP H 11 - 247962 A relates to a feed screw used as a linear movement mechanism. A screw shaft and a nut are machined so that the tooth surface of the screw shaft is parallel with a tooth surface of the nut. A tooth thickness Ln of the nut is larger than a tooth thickness Ls of the screw shaft while a tooth height Hs of the screw shaft is larger than a tooth height Hs of the screw shaft these dimensions Ln, Ls, Hn, Hs determined so that the deformed inclination of the tooth of the nut becomes equal to the deformed inclination of the tooth on the screw shaft site upon load application. In consideration of the wear resistance and the seizure resistance, materials such as S55C (carbon steel for machine structures), SCM (chromium-molybdenum-steel steel materials), or SNCM (nickel-chrome-molybdenum-steel steel materials) are usually used for the screw shaft side.

### Summary of Invention

In the case where the ball screw shaft described in Japanese Laid-Open Patent Publication No. 2014-047884 is used, the size of the nut screw-engaged with the ball screw shaft is relatively large, and consequently, the electric actuator has a large size. Further, large operation noises due to circulation of steel balls are produced disadvantageously. In contrast, in the case where the sliding screw shaft is used, the size of the nut screw-engaged with the sliding screw shaft and the operation noises can be reduced relatively. However, abrasion occurs easily in comparison with the case where the ball screw shaft is used. Further, in an attempt of reducing the weight and the size of the electric actuator, it may be possible to adopt the sliding screw shaft and nut made of light metal such as aluminum or light metal alloy such as aluminum alloy to thereby reduce the load (inertial force) on the motor. However, in this case, abrasion of the sliding screw shaft and the nut tends to occur more easily. Further, it is desired to achieve further noise reduction in the case of electric actuators used in hospitals, etc.

In view of the above problems, the inventors of the present application conducted stress analysis of the sliding screw shaft and the nut at the time of operating the electric actuator, and found that stress concentration occurs on a region of a threaded part of the nut that is located within a range from the starting end (terminating end) to the third thread of the threaded part in an axial direction thereof. Further, the inventors of the present application found that it is effective to form a diamond-like carbon film on at least one of the region of the threaded part of the nut, which is located within a range from the starting end to the third thread in the axial direction, and a threaded part of the sliding screw shaft, in suppressing of sliding noises generated between the nut and the sliding screw shaft (in achieving an almost silent state).

The present invention has been made taking such tasks into account, and an object of the present invention is to provide an electric actuator which makes it possible to improve the abrasion resistance and the durability of a sliding screw shaft and a nut, and achieve reduction of the weight, size and noises.

The above technical problem is solved by an electric actuator according to any of the independent claims.

An electric actuator according to the present invention includes a sliding screw shaft, and a nut screw-engaged with the sliding screw shaft, the sliding screw shaft being configured to rotate under operation of a motor to thereby cause the nut to be displaced in an axial direction of the sliding screw shaft. The sliding screw shaft is made of light metal or light metal alloy. A diamond-like carbon film is formed on a region of a threaded part of the nut, the region being located within a range from a starting end of the threaded part of the nut in an axial direction thereof to at least a third thread of the threaded part of the nut.

In the electric actuator according to the present invention, since the sliding screw shaft is made of light metal or light metal alloy, it is possible to reduce the load (inertia force) on the motor. Therefore, it is possible to reduce the size of the motor. Stated otherwise, it is possible to increase the maximum working load of the electric actuator without increasing the size (output) of the motor. Further, since the sliding screw shaft is used instead of the ball screw shaft, it is possible to reduce the size of the nut. Further, since a diamond-like carbon film is formed on a region of the threaded part of the nut that is located within a range from the starting end in the axial direction to at least the third thread, and optionally on the threaded part of the sliding screw shaft, it is possible to reduce abrasion of the sliding screw shaft and the nut and improve the efficiency of the screw, while suppress sliding noises generated between the sliding screw shaft and the nut. Accordingly, it is possible to improve the abrasion resistance and the durability of the sliding screw shaft and the nut, and achieve reduction of the weight, size and noises of the electric actuator.

In the above electric actuator, preferably, the diamond-like carbon film is formed on a region of the threaded part of the nut that is located within the range from the starting end to at least the third thread, and on a region thereof that is located within a range from a terminating end of the threaded part of the nut in the axial direction to at least a third thread of the threaded part of the nut. In the structure, it is possible to further reduce abrasion of the sliding screw shaft and the nut.

In the above electric actuator, preferably, the thickness of the diamond-like carbon film on a first starting end portion of the threaded part of the nut that is located at a first thread from the starting end is larger than the thickness of the diamond-like carbon film on a second starting end portion of the threaded part of the nut that is located at a second thread from the starting end.

In the above structure, since the thickness of the diamond-like carbon film on the first starting end portion of the nut where stress tends to be concentrated at the time of operating the electric actuator is relatively large, it is possible to improve the durability of the sliding screw shaft and the nut.

According to a first aspect of the present invention, in the electric actuator, the thickness of the diamond-like carbon film on a first terminating end portion of the threaded part of the nut that is located at a first thread from the terminating end is larger than the thickness of the diamond-like carbon film on a second terminating end portion of the threaded part of the nut that is located at a second thread from the terminating end.

In the above structure, since the thickness of the diamond-like carbon film on the first terminating end portion of the nut where stress tends to be concentrated at the time of operating the electric actuator is relatively large, it is possible to improve the durability of the sliding screw shaft and the nut to a greater extent.

According to a second aspect of the present invention, in the electric actuator, the diamond-like carbon film is formed on a region of the threaded part of the nut that is located within a range from the starting end to the terminating end. With the above structure, it is possible to further improve the efficiency of the screw, and suppress sliding noises generated between the sliding screw shaft and the nut to a greater extent.

In the this electric actuator, the thickness of the diamond-like carbon film on the region of the threaded part of the nut that is located within the range from the starting end to the third thread and on the region thereof that is located within the range from the terminating end to the third thread is larger than a thickness of the diamond-like carbon film on an intermediate region of the threaded part of the nut, the intermediate region being located within a range from a fourth thread from the starting end to a fourth thread from the terminating end.

In the structure, since the thickness of the diamond-like carbon film on the regions of the threaded part of the nut that are located within a range from the starting end to the third thread and a range from the terminating end to the third thread where stress tends to be concentrated at the time of operating the electric actuator is relatively large, it is possible to improve the durability of the sliding screw shaft and the nut effectively.

According to a third aspect of the invention, in the electric actuator, the diamond-like carbon film is not be formed on at least part of an intermediate region of the threaded part of the nut that is located within a range from a fourth thread from the starting end to a fourth thread from the terminating end.

In the structure, in comparison with the case where the diamond-like carbon film is formed on a region of the thread part of the nut that is located within a range from the starting end to the terminating end, it becomes possible to reduce the production cost of the electric actuator.

In the above electric actuator, the diamond-like carbon film may preferably be formed on both of the region of the threaded part of the nut, which is located within the range from the starting end to at least the third thread, and the threaded part of the sliding screw shaft. In the structure, it is possible to improve the abrasion resistance of the sliding screw shaft and the nut to a greater extent.

In the above electric actuator, the sliding screw shaft may be made of aluminum or aluminum alloy, an alumite film may be formed on the threaded part of the sliding screw shaft, and the diamond-like carbon film may be formed on the region of the threaded part of the nut, which is located within the range from the starting end to at least the third thread.

In the above electric actuator, preferably, the nut is made of light metal or light metal alloy. In the structure, since it is possible to reduce the load on the motor to a greater extent, it is possible to achieve further reduction of the weight and size of the electric actuator.

In the above electric actuator, the diamond-like carbon film may be formed on the threaded part of the sliding screw shaft, the nut may be made of aluminum or aluminum alloy, and an alumite film may be formed on the threaded part of the nut.

In the above electric actuator, the diamond-like carbon film may be formed on the threaded part of the sliding screw shaft, the nut may be made of iron or iron alloy, and a chromium film or a nickel film may be formed on the threaded part of the nut.

In the above electric actuator, preferably, the thickness of the diamond-like carbon film is 0.1 µm or more and 6.0 µm or less. In the structure, since the thickness of the diamond-like carbon film is 0.1 µm or more, it is possible to suitably suppress early peeling of the diamond-like carbon film due to abrasion. Further, since the thickness of the diamond-like carbon film is 6.0 µm or less, it is possible to reliably form the diamond-like carbon film.

In the above electric actuator, preferably, the sliding screw shaft has clearance space, and crests of the threaded part of the nut are placed in the clearance space in a state where the crests and the sliding screw shaft do not contact each other. In the structure, even in the case where burrs produced at the crests of the threaded part of the nut are not completely removed, it is possible to prevent the damage to the threaded part (DLC film) of the sliding screw shaft due to the burrs.

In the above electric actuator, the clearance space may be configured to store lubricant. In the structure, since it is possible to efficiently supply lubricant to a clearance (gap) between the sliding screw shaft and the nut, it is possible to improve the abrasion resistance and the durability of the sliding screw shaft to a greater extent, and achieve further noise reduction of the electric actuator.

In the present invention, since the diamond-like carbon film is formed on at least one of a region of the threaded part of the nut that is located within a range from the starting end of the threaded part of the nut in the axial direction to at least the third thread, and the threaded part of the sliding screw shaft, it is possible to effectively improve the abrasion resistance and the durability of the sliding screw shaft and the nut, and achieve reduction of the weight, size, and noises.

### Brief Description of Drawings

FIG. 1 is a perspective view showing an electric actuator according to a first embodiment of the present invention;
FIG. 2 is an exploded perspective view showing the electric actuator in FIG. 1;
FIG. 3 is a vertical cross sectional view with partial omission showing the electric actuator in FIG. 1;
FIG. 4 is a partial enlarged view showing the electric actuator in FIG. 3;
FIG. 5 is an enlarged vertical cross sectional view of a nut shown in FIG. 2;
FIG. 6A is an enlarged vertical cross sectional view showing a nut according to a first modification of the embodiment and FIG. 6B is an enlarged vertical cross sectional view showing a nut according to a second modification of the embodiment;
FIG. 7 is a perspective view showing an electric actuator according to a second embodiment of the present invention;
FIG. 8 is an exploded perspective view showing the electric actuator in FIG. 7;
FIG. 9 is a vertical cross sectional view with partial omission showing the electric actuator in FIG. 7;
FIG. 10 is a partial enlarged cross sectional view showing the electric actuator in FIG. 7;
FIG. 11 is an enlarged cross sectional view showing a sliding screw shaft and a nut in FIG. 9; and
FIG. 12 is an enlarged cross sectional view showing a part of the view in FIG. 11.

### Description of Embodiments

Hereinafter, preferred embodiments of an electric actuator according to the present invention will be described with reference to the drawings.

### (First embodiment)

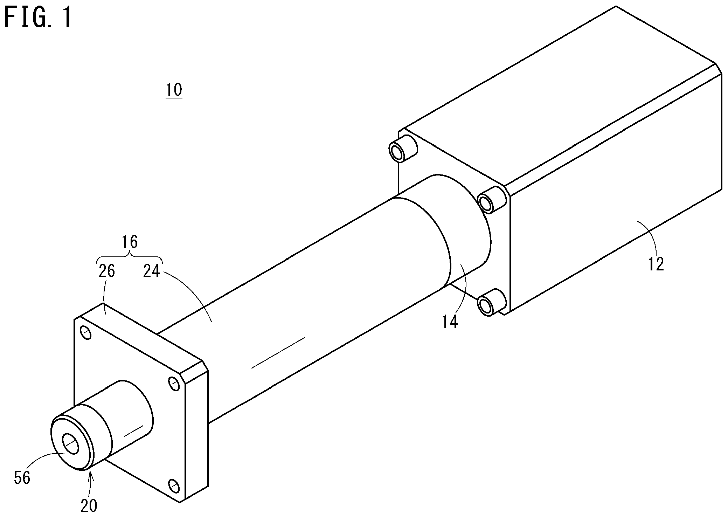

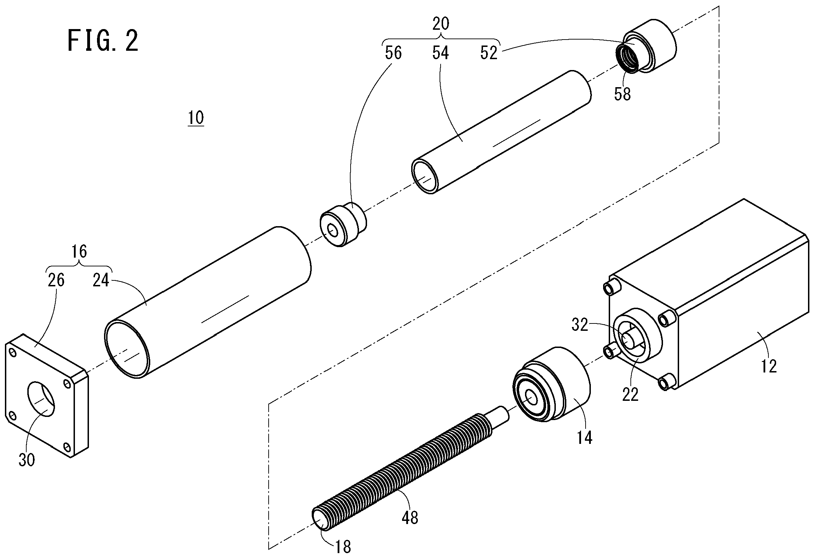

As shown in FIGS. 1 to 3, an electric actuator 10 according to a first embodiment of the present invention includes a motor 12 as a rotary drive source, a rod cover 16 disposed on the motor 12 through a housing 14, a sliding screw shaft (feed screw shaft) 18 for transmitting a rotary drive force of the motor 12, and a displaceable part 20 which is displaced in accordance with rotation of the sliding screw shaft 18. In FIGS. 1 to 3, it should be noted that the right side (motor 12 side) of the sliding screw shaft 18 will be referred to as the "proximal end" side, and the left side (socket 56 side) of the sliding screw shaft 18 will be referred to as the "distal end" side.

For example, the motor 12 may be a servo motor such as a brushed DC motor, a brushless DC motor, or a stepping motor.

The housing 14 has an annular shape. The housing 14 is externally fitted onto a motor adaptor 22 of the motor 12. The rod cover 16 includes an elongated outer cylinder 24 externally fitted onto the housing 14, and an end block 26 provided at the distal end of the outer cylinder 24. The outer cylinder 24 is a tube member having a cylindrical shape. A rod 54 of the displaceable part 20 described later is provided inside the outer cylinder 24. The end block 26 has a quadrangular shape in a front view. An insertion hole 30 is formed at the center of the end block 26 for inserting the rod 54 into the insertion hole 30.

The sliding screw shaft 18 is coupled to a motor shaft through a coupling 32. In the embodiment of the present invention, the coupling 32 may be omitted in the case of using one common shaft as the sliding screw shaft 18 and the motor shaft.

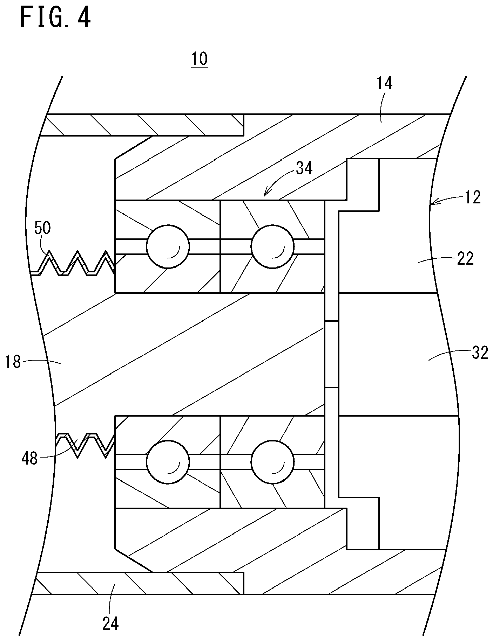

As can be understood from FIG. 4, a bearing 34 is provided at the proximal end of the sliding screw shaft 18. For example, a rolling bearing may be used as the bearing 34. Alternatively, a sliding bearing may be used as the bearing 34.

The sliding screw shaft 18 is made of light metal such as aluminum or light metal alloy such as aluminum alloy. The light metal herein means metal having a specific gravity of 4 or less. As described above, in the case where the sliding screw shaft 18 is made of light metal or light metal alloy, in comparison with the case where the sliding screw shaft 18 is made of heavy metal (metal having a specific gravity of more than 4) such as iron, the load on the motor 12 is reduced, and the weight reduction of the electric actuator 10 is achieved. Further, a diamond-like carbon film (hereinafter referred to as the "DLC film 50") is formed on all threads of a threaded part 48 of the sliding screw shaft 18 (see FIG. 4).

The DLC film 50 is an amorphous hard film made of hydrocarbon or allotrope of carbon, having excellent lubricating performance, abrasion resistance, seizure resistance, etc. For example, the DLC film 50 may be formed by CVD (Chemical Vapor Deposition) or PVD (Physical Vapor Deposition), etc. Further, in order to enhance the adhesion performance between the DLC film 50 and the base material (the threaded part 48 of the sliding screw shaft 18), an intermediate layer may be formed between the base material and the DLC film 50. For example, the intermediate layer may be made of a composite layer of the base material and DLC. In this case, with the approach to the base material, the composition ratio of metal in the intermediate layer gets higher and the composition ratio of DLC in the intermediate layer gets lower. On the other hand, with distance from the base material, the composition ratio of metal in the intermediate layer gets lower and the composition ratio of DLC in the intermediate layer gets higher. Using the intermediate layer having this structure, it is possible to suitably suppress peeling of the DLC film 50 from the base material.

Preferably, the thickness of the DLC film 50 is 0.1 µm or more and 6.0 µm or less, more preferably, 0.3 µm or more and 4.0 µm or less, much more preferably, 0.5 µm or more and 3.5 µm or less. This is because, if the thickness of the DLC film 50 is less than 0.1 µm, there is a concern of early peeling of the DLC film 50 due to abrasion, and if the thickness of the DLC film 50 is more than 6.0 µm, it is not easy to form the DLC film 50, the cost of the DLC film 50 becomes high, and pealing of the DLC film 50 occurs easily. Further, preferably, the thickness of the DLC film 50 is larger than the surface roughness Rz (distance between peak and valley of the roughness on the surface) of the counterpart material (DLC film 60 described later). The same applies to the DLC film 60.

The displaceable part 20 includes a nut 52 screw-engaged with the sliding screw shaft 18, a cylindrical rod 54 fixed to the nut 52 and inserted into the insertion hole 30 of the end block 26, and a socket 56 attached to the rod 54 to close the opening at the distal end of the rod 54.

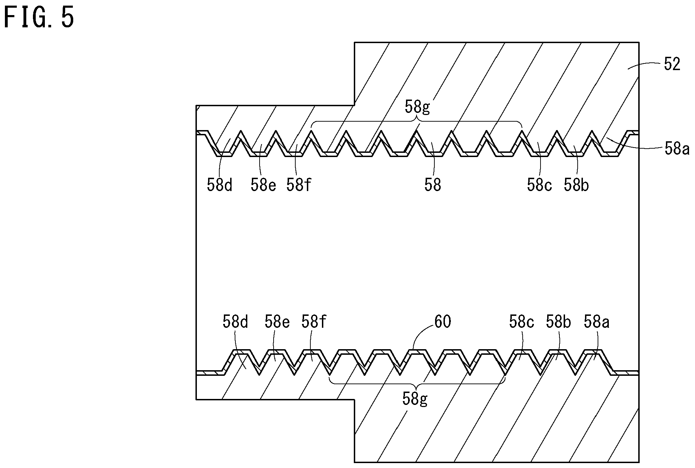

The nut 52 is made of light metal such as aluminum or light metal alloy such as aluminum alloy. In the structure, the load on the motor 12 is reduced to a greater extent, and the weight reduction of the electric actuator 10 is achieved. Further, the DLC film 60 is formed on all threads of a threaded part 58 of the nut 52 (see FIG. 5). The structure of the DLC film 60, and the method of forming the DLC film 60 are the same as in the case of the DLC film 50 formed on the threaded part 48 of the sliding screw shaft 18, and the description thereof is omitted.

In the following description, the right end (end on the motor 12 side) in FIG. 5 of the threaded part 58 of the nut 52 will be referred to as the "starting end", and the left end (end on the socket 56 side) in FIG. 5 of the threaded part 58 of the nut 52 will be referred to as the "terminating end". However, it is a matter of course that the positions of the starting end and the terminating end may be left-right reversed.

The thickness of the DLC film 60 on a portion (first starting end portion 58a) of the threaded part 58 of the nut 52 (threaded part 58 as a complete thread part) that is located at a first thread from the starting end of the threaded part 58 in an axial direction thereof is larger than the thickness of the DLC film 60 on a portion (second starting end portion 58b) of the threaded part 58 of the nut 52 that is located at a second thread from the starting end. Further, the thickness of the DLC film 60 on the second starting end portion 58b is larger than the thickness of the DLC film 60 on a portion (third starting end portion 58c) of the threaded part 58 of the nut 52 that is located at a third thread from the starting end.

The thickness of the DLC film 60 on a portion (first terminating end portion 58d) of the threaded part 58 of the nut 52 that is located at a first thread from the terminating end of the threaded part 58 in the axial direction is larger than the thickness of the DLC film 60 on a portion (second terminating end portion 58e) of the threaded part 58 of the nut 52 that is located at a second thread from the terminating end. Further, the thickness of the DLC film 60 on the second terminating end portion 58e is larger than the thickness of the DLC film 60 on a portion (third terminating end portion 58f) of the threaded part 58 of the nut 52 that is located at a third thread from the terminating end.

The thickness of the DLC film 60 on the third starting end portion 58c and the thickness of the DLC film 60 on the third terminating end portion 58f are equal to or larger than the thickness of the DLC film 60 on a region of the threaded part 58 of the nut 52 that is located within a range from a fourth thread from the starting end, to a fourth thread from the terminating end (i.e., an intermediate region 58g between the third starting end portion 58c and the third terminating end portion 58f exclusive).

In the present embodiment, the thickness of the DLC film 60 on the first starting end portion 58a and the first terminating end portion 58d is 0.9 µm, the thickness of the DLC film 60 on the second starting end portion 58b and the second terminating end portion 58e is 0.8 µm, and the thickness of the DLC film 60 on the third starting end portion 58c, the third terminating end portion 58f, and the intermediate region 58g is 0.5 µm. It should be noted that the thickness of the DLC film 60 formed on the threaded part 58 of the nut 52 can be determined freely.

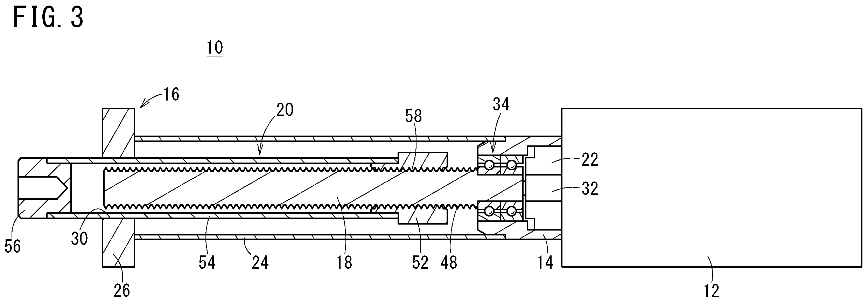

The electric actuator 10 according to the present embodiment basically has the above structure. Next, operation and advantages of the electric actuator 10 will be described below. In the following description, a state where the rod 54 is placed in the interior of the outer cylinder 24 as shown in FIGS. 1 and 3 will be referred to as an initial position.

In this initial position, electrical current is supplied from a power supply (not shown) to the motor 12 to thereby rotate the motor shaft. As a result, the rotary drive force of the motor shaft is transmitted to the sliding screw shaft 18 through the coupling 32. Then, by rotation of the sliding screw shaft 18, the rod 54 and the socket 56 are displaced together with the nut 52 toward the distal end side (in a direction opposite to the motor 12). At this time, stress is concentrated on the first to third starting end portions 58a to 58c of the threaded part 58 of the nut 52. However, since the DLC film 60 is formed on the first to third starting end portions 58a to 58c, and the DLC film 50 is formed on all the threads of the threaded part 48 of the sliding screw shaft 18, it becomes possible to smoothly displace the nut 52 in the axial direction of the sliding screw shaft 18 toward the distal end side.

In the case where the rod 54 is returned to the initial position, the motor shaft is rotated in a direction opposite to the above. In this manner, the rotary drive force of the motor shaft is transmitted to the sliding screw shaft 18 through the coupling 32. Then, by rotation of the sliding screw shaft 18 in the direction opposite to the above, the rod 54 and the socket 56 are displaced together with the nut 52 toward the proximal end side (motor 12 side). At this time, stress is concentrated on the first to third terminating end portions 58d to 58f of the threaded part 58 of the nut 52. However, since the DLC film 60 is formed on the first to third terminating end portions 58d to 58f, and the DLC film 50 is formed on all the threads of the threaded part 48 of the sliding screw shaft 18, it becomes possible to smoothly displace the nut 52 in the axial direction of the sliding screw shaft 18 toward the proximal end side.

In the present embodiment, since the sliding screw shaft 18 is made of light metal or light metal alloy, it is possible to reduce the load (inertial force) on the motor 12. In the structure, size reduction of the motor 12 is achieved. Stated otherwise, it is possible to increase the maximum working load of the electric actuator 10 without increasing the size (output) of the motor 12.

Further, since the sliding screw shaft 18 is used instead of the ball screw shaft, it is possible to reduce the size of the nut 52. Further, the DLC film 60 is formed on portions (region) of the threaded part 58 of the nut 52 that are located within a range from the starting end to the terminating end of the threaded part 58, and the DLC film 50 is formed on the threaded part 48 of the sliding screw shaft 18. Therefore, abrasion of the sliding screw shaft 18 and the nut 52 is reduced, and improvement in the efficiency of the screw (ratio of the screw output to the screw input) is achieved. Further, sliding noises generated between the sliding screw shaft 18 and the nut 52 can be suppressed. Thus, it is possible to improve the abrasion resistance and the durability of the sliding screw shaft 18 and the nut 52, and achieve reduction of the weight, size and noises of the electric actuator 10.

In the present embodiment, the thickness of the DLC film 60 on the first starting end portion 58a of the threaded part 58 of the nut 52 is larger than the thickness of the DLC film 60 on the second starting end portion 58b, and the thickness of the DLC film 60 on the first terminating end portion 58d is larger than the thickness of the DLC film 60 on the second terminating end portion 58e. That is, since the thickness of the DLC film 60 on the first starting end portion 58a and the first terminating end portion 58d where stress tends to be concentrated at the time of operating the electric actuator 10 is relatively large, it is possible to improve the durability of the sliding screw shaft 18 and the nut 52.

Further, since the thickness of the DLC film 60 on the first to third starting end portions 58a to 58c and the first to third terminating end portions 58d to 58f is equal to or larger than the thickness of the DLC film 60 on the intermediate region 58g, the durability of the sliding screw shaft 18 and the nut 52 is improved efficiently.

In the present embodiment, since the nut 52 is made of light metal or light metal alloy, it is possible to further reduce the load on the motor 12. Accordingly, it is possible to achieve weight reduction and the size reduction of the electric actuator 10 to a greater extent.

Further, since the thickness of the DLC films 50, 60 is 0.1 µm or more, it is possible to suitably suppress early peeling of the DLC films 50, 60 due to abrasion. Further, since the thickness of the DLC film 50, 60 is 6.0 µm or less, it is possible to reliably form the DLC films 50, 60.

The electric actuator 10 according to the present embodiment is not limited to the above structure. In the present embodiment, it is sufficient that the sliding screw shaft 18 is made of light metal or light metal alloy, and the DLC film 50, 60 is formed on at least one of a region of the threaded part 58 of the nut 52 and the threaded part 48 of the sliding screw shaft 18, the region of the threaded part 58 being located within a range from the starting end of the threaded part 58 to at least a third thread of the threaded part 58 in an axial direction thereof. That is, in the present embodiment, for example, combination of the sliding screw shaft 18 and the nut 52 shown in Table 1 can be adopted.

**[Table 1]**

| | Sliding screw shaft | | Nut | |
|---|---|---|---|---|
| | Constituent Material | Film | Constituent Material | Film |
| 1 | Light metal or light metal alloy | DLC | Light metal or light metal alloy | DLC |
| 2 | Light metal or light metal alloy | DLC | Aluminum or aluminum alloy | Alumite |
| 3 | Aluminum or aluminum alloy | Alumite | Light metal or light metal alloy | DLC |
| 4 | Light metal or light metal alloy | DLC | Copper or copper alloy | DLC |
| 5 | Aluminum or aluminum alloy | Alumite | Copper or copper alloy | DLC |
| 6 | Light metal or light metal alloy | DLC | Iron or iron alloy | DLC |
| 7 | Light metal or light metal alloy | DLC | Iron or iron alloy | Hard chromium |
| 8 | Light metal or light metal alloy | DLC | Iron or iron alloy | Nickel |
| 9 | Aluminum or aluminum alloy | Alumite | Iron or iron alloy | DLC |

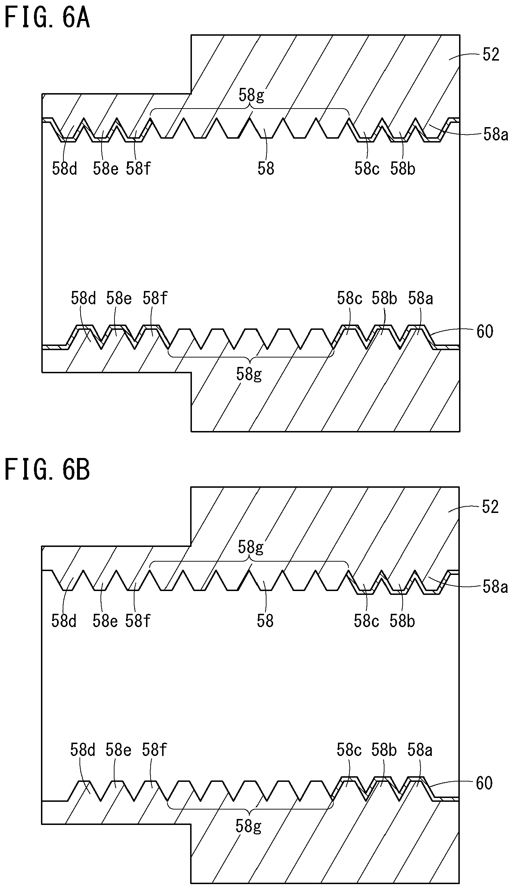

Further, in the case of forming the DLC film 60 on the threaded part 58 of the nut 52, for example, as shown in FIG. 6A, the DLC film 60 may not be formed on at least part of the intermediate region 58g (in FIG. 6A, not formed on any of the intermediate region 58g), and the DLC film 60 may be formed on the first to third starting end portions 58a to 58c and the first to third terminating end portions 58d to 58f. Alternatively, for example, as shown in FIG. 6B, the DLC film 60 may not be formed on the first to third terminating end portions 58d to 58f or the intermediate region 58g, and the DLC film 60 may be formed on the first to third starting end portions 58a to 58c. In the modifications of the embodiment shown in FIGS. 6A and 6B, it is possible to achieve reduction of the production cost of the electric actuator 10 to a greater extent.

### (Second embodiment)

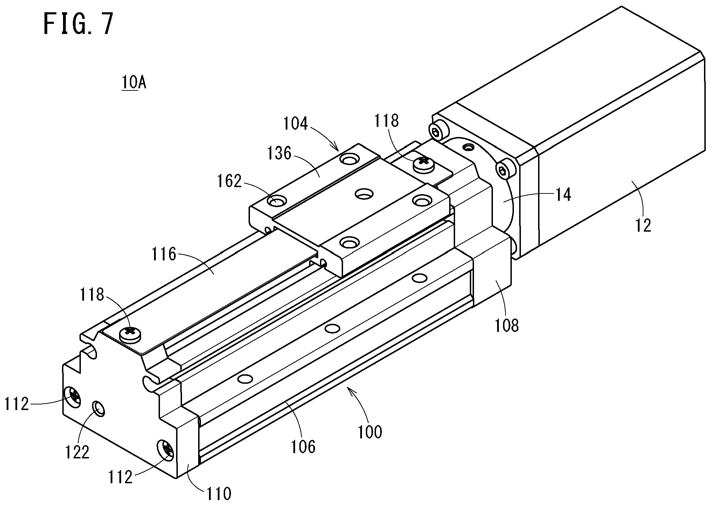

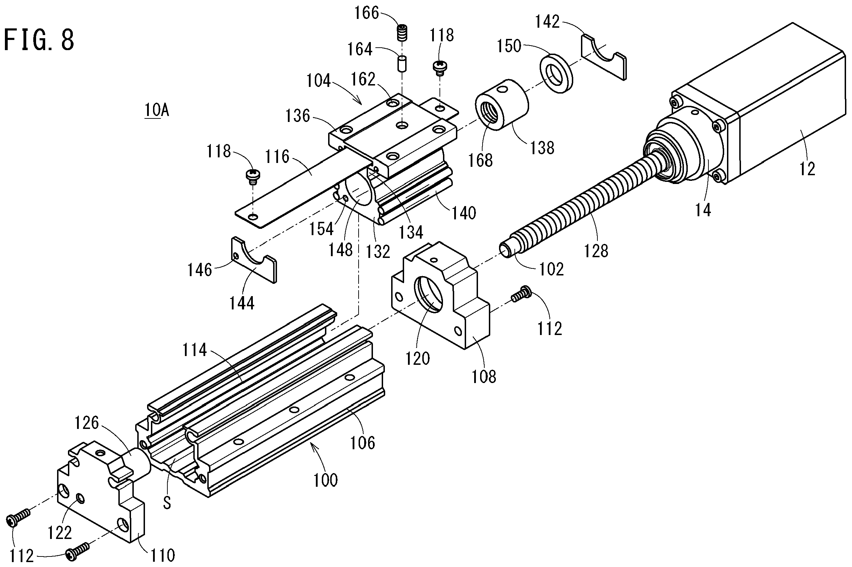

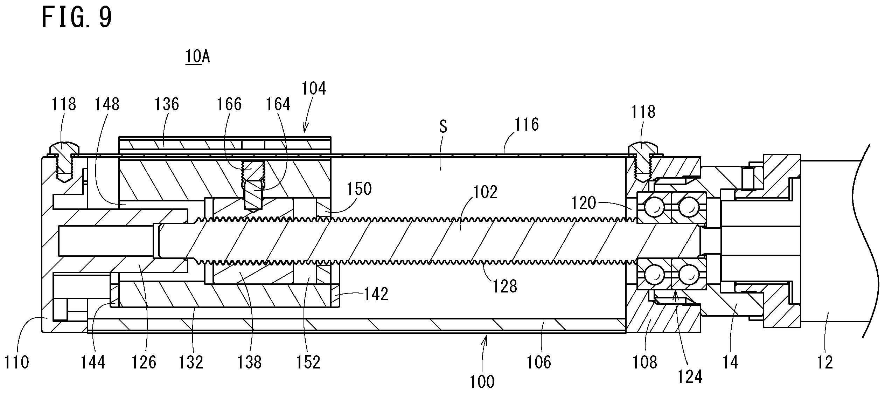

Next, an electric actuator 10A according to a second embodiment of the present invention will be described with reference to FIGS. 7 to 12. The constituent elements of the electric actuator 10A according to the second embodiment that are identical to those of the electric actuator 10 according to the first embodiment are labeled with the same reference numerals, and detailed description thereof is omitted.

As shown in FIGS. 7 to 10, the electric actuator 10A according to the second embodiment includes a motor 12 as a rotary drive source, a base part 100 disposed on the motor 12 through a housing 14, a sliding screw shaft (feed screw shaft) 102 for transmitting a rotary drive force of the motor 12, and a displaceable part 104 which is displaced in accordance with rotation of the sliding screw shaft 102.

The base part 100 includes a base part main body 106 having a U-shape in cross section and which extends in an axial direction of the sliding screw shaft 102, a first end plate 108 provided at the proximal end (end on the motor 12 side) of the base part main body 106, and a second end plate 110 provided at the distal end (end opposite to the motor 12) of the base part main body 106. Each of the first end plate 108 and the second end plate 110 is fixed to the base part main body 106 using a plurality of fixing screws 112.

That is, the base part 100 has a space S formed by the base part main body 106, the first end plate 108, and the second end plate 110. The displaceable part 104 is placed in the space S. An opening 114 communicating with the space S is formed over the entire length of the base part main body 106. The opening 114 is covered by a plate-shaped cover part 116. In the structure, it is possible to suppress entry of dust from the outside of the base part 100 into the space S through the opening 114. The cover part 116 is fixed to the first end plate 108 and the second end plate 110 by fixing screws 118.

An insertion hole 120 is formed in the first end plate 108. The housing 14 is internally fitted into the insertion hole 120, and the sliding screw shaft 102 is inserted into the insertion hole 120. An oil supply hole 122 is formed in the second end plate 110 for supplying grease to the sliding screw shaft 102 and a grease reservoir 152 described later.

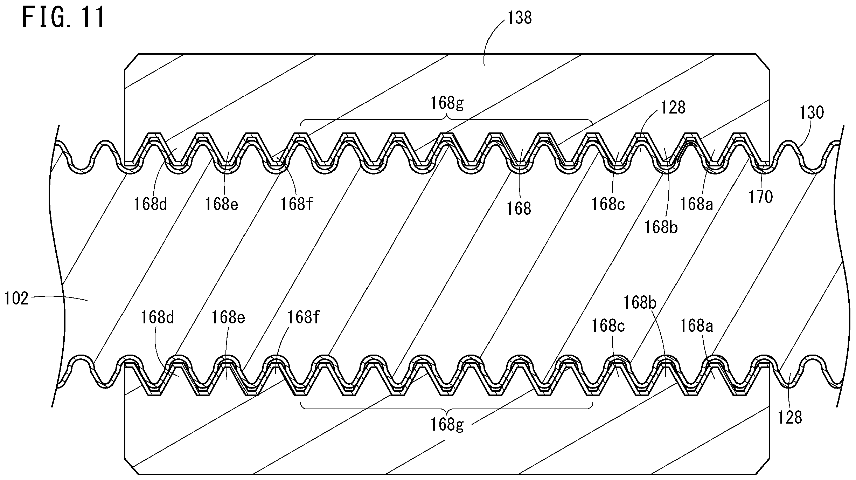

The proximal end of the sliding screw shaft 102 is axially supported by the a rolling bearing 124 provided in the housing 14, and the distal end thereof is axially supported by a slide bearing 126 provided in the second end plate 110. The sliding screw shaft 102 is made of light metal such as aluminum or light metal alloy such as aluminum alloy. The DLC film 130 is formed on all threads of a threaded part 128 of the sliding screw shaft 102. The DLC film 130 can be formed in the same manner as the above described DLC film 50 (see FIG. 11).

The displaceable part 104 includes a displaceable part main body 132 having a block shape (rectangular parallelepiped shape) and which is provided in the space S of the base part 100, a neck part 134 extending from the displaceable part main body 132 and inserted into the opening 114 of the base part 100, a table 136 provided on the neck part 134, and a nut 138 provided in the displaceable part main body 132 and screw-engaged with the sliding screw shaft 102.

A plurality of guide pins 140 are provided on both side surfaces of the displaceable part main body 132. The guide pins 140 extend in the axial direction of the sliding screw shaft 102, and slide on the inner surfaces of the base part main body 106. These guide pins 140 are positioned with respect to the displaceable part main body 132 in the axial direction of the sliding screw shaft 102 using a first stopper 142 fixed to the proximal end surface of the displaceable part main body 132, and a second stopper 144 fixed to the distal end surface of the displaceable part main body 132. A communication hole 146 is formed in the second stopper 144, at a position facing the oil supply hole 122 of the second end plate 110.

A circular nut hole 148 is formed in the displaceable part main body 132. The nut 138 is disposed in the nut hole 148. An annular cap 150 is provided in the nut hole 148 on one side of the nut 138 closer to the first stopper 142. The cap 150 is fixed to a wall surface of the nut hole 148. The sliding screw shaft 102 is inserted into an inner hole of the cap 150. That is, the grease reservoir 152 is formed between the nut 138 and the cap 150 for guiding the grease into a clearance between the nut 138 and the sliding screw shaft 102.

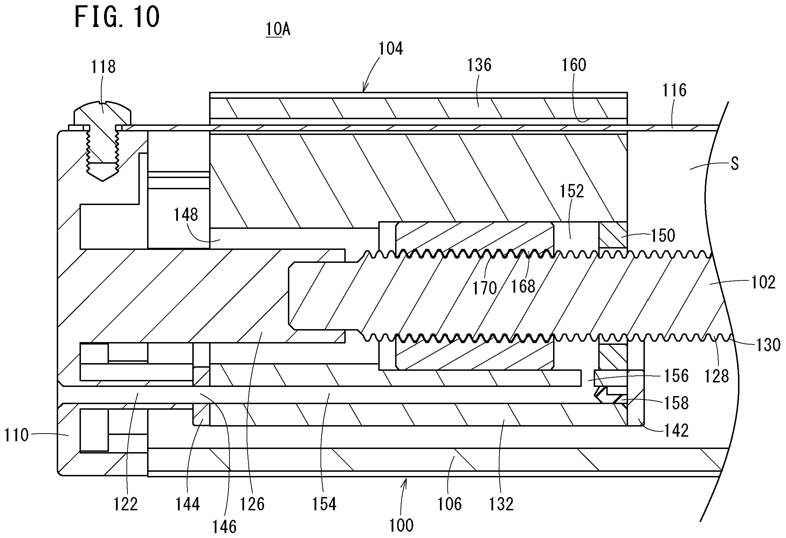

Further, as shown in FIG. 10, the displaceable part main body 132 has a through hole 154 and an inlet hole 156. The through hole 154 extends over the entire length of the displaceable part main body 132, and communicates with the communication hole 146 of the second stopper 144. The inlet hole 156 connects the through hole 154 and the grease reservoir 152. A packing (closing member) 158 is provided in the through hole 154. The packing 158 closes an opening of the through hole 154 on the first stopper 142 side. By this packing 158, it is possible to suppress leakage of grease from a gap between the displaceable part main body 132 and the first stopper 142.

The table 136 is wider than the displaceable part main body 132. An insertion hole 160 is formed in the table 136, and the cover part 116 is inserted into the insertion hole 160. In the structure, when the displaceable part 104 is displaced with respect to the base part 100, the displaceable part 104 never interferes with the cover part 116. A plurality of attachment holes 162 are formed in a table 136 for attaching a workpiece (not shown), etc. to the table 136.

The nut 138 has a cylindrical shape. The nut 138 is displaced in the axial direction by rotation of the sliding screw shaft 102. In a state where the nut 138 is placed in the nut hole 148, the nut 138 is fixed to the displaceable part main body 132 by a pin 164 and a setscrew 166. The nut 138 is made of light metal such as aluminum or light metal alloy such as aluminum alloy. As shown in FIG. 11, the DLC film 170 is formed on all threads of a threaded part 168 of the nut 138. The DLC film 170 is formed in the same manner as the DLC film 60 described above.

That is, the thickness of the DLC film 170 on the first starting end portion 168a of the threaded part 168 of the nut 138 is larger than the thickness of the DLC film 170 on the second starting end portion 168b of the threaded part 168 of the nut 138. Further, the thickness of the DLC film 170 on the second starting end portion 168b of the threaded part 168 of the nut 138 is larger than the thickness of the DLC film 170 on the third starting end portion 168c of the threaded part 168 of the nut 138.

The thickness of the DLC film 170 on the first terminating end portion 168d of the threaded part 168 of the nut 138 is larger than the thickness of the DLC film 170 on the second terminating end portion 168e of the threaded part 168 of the nut 138. Further, the thickness of the DLC film 170 on the second terminating end portion 168e of the threaded part 168 of the nut 138 is larger than the thickness of the DLC film 170 on the third terminating end portion 168f of the threaded part 168 of the nut 138.

The thickness of the DLC film 170 on the third starting end portion 168c and the thickness of the DLC film 170 on the third terminating end portion 168f are equal to or more than the thickness of the DLC film 170 on the intermediate region 168g of the threaded part 168 of the nut 138.

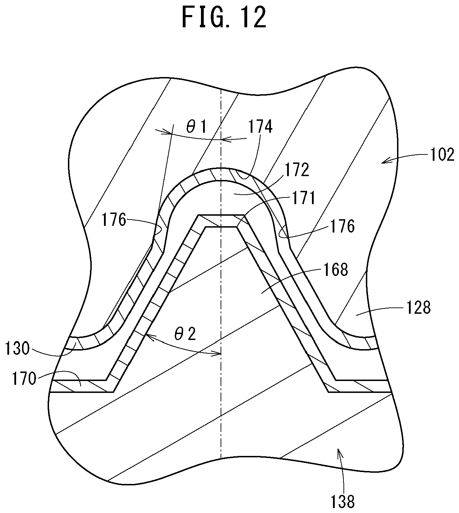

Further, as shown in FIG. 12, the top surface of each thread of the threaded part 168 of the nut 138 has a flat shape in cross section in the axial direction of the sliding screw shaft 102. In general, burrs tend to be produced at a tip end corner 171 of the thread of the threaded part 168 of the nut 138 due to machining. These burrs can be removed by shot blasting or chemical polishing, etc. However, it is not easy to check removal of the burrs visually. Therefore, in the case where the burrs remain at the tip end corner 171 of the thread of the threaded part 168 of the nut 138, the DLC film 130 of the threaded part 128 of the sliding screw shaft 102 may be damaged due to the burrs.

In the present embodiment, in order to prevent the damage to the DLC film 130 of the sliding screw shaft 102, clearance space 172 is formed at each root of the threaded part of the sliding screw shaft 102, and the tip end corner (crest) 171 of the threaded part 168 of the nut 138 is placed in the clearance space 172. Specifically, the wall surface of the clearance space 172 includes a curved surface 174 having a semicircular shape in cross section in the axial direction of the sliding screw shaft 102, and a pair of flat surfaces 176 joined respectively to both sides of the curved surface 174 in the axial direction of the sliding screw shaft 102.

The pair of flat surfaces 176 are inclined to spread toward a direction away from the curved surface 174. In this state, the flat surfaces 176 extend beyond the crest of the threaded part 168 of the nut 138 toward the root thereof to some extent. The angle (acute angle) θ1 formed between a line perpendicular to the axis of the sliding screw shaft 102 and each flat surface 176 is smaller than the flank angle θ2 of the nut 138. In the structure, in a state where the sliding screw shaft 102 is screw-engaged with the nut 138, each flat surface 176 (sliding screw shaft 102) does not contact the tip end corner 171 of each thread of the threaded part 168 of the nut 138. Therefore, even in the case where the burrs produced at the tip end corner 171 of the threaded part 168 of the nut 138 are not completely removed, it is possible to prevent the damage to the DLC film 130 on the threaded part 128 of the sliding screw shaft 102 due to the burrs. In the case where the DLC film 130 is not formed on the threaded part 128 of the sliding screw shaft 102, it is possible to prevent the damage to the threaded part 128 of the sliding screw shaft 102.

The clearance space 172 also functions as a grease retaining space for retaining the grease guided from the grease reservoir 152. That is, the clearance space 172 is formed to be capable of storing the grease (lubricant). In the structure, it is possible to efficiently supply the grease to the gap between the sliding screw shaft 102 and the nut 138, and thus, improve the abrasion resistance and durability of the sliding screw shaft 102 and the nut 138, and achieve further noise reduction of the electric actuator 10A.

Further, in the present embodiment, if the amount of grease in the grease reservoir 152 becomes small, it is possible to supply the grease to the grease reservoir 152 easily. More specifically, at the time of supplying the grease, the displaceable part 104 is moved toward the distal end with respect to the sliding screw shaft 102.

Then, the second stopper 144 contacts the second end plate 110, and the oil supply hole 122 of the second end plate 110 is placed in communication with the communication hole 146 of the second stopper 144. Stated otherwise, the oil supply hole 122 is placed in communication with the grease reservoir 152 through the communication hole 146, the through hole 154, and the inlet hole 156. At this time, by action of the packing 158, leakage of the grease from the gap between the displaceable part main body 132 and the first stopper 142 is suppressed. Further, in this state, the grease is injected through the oil supply hole 122 into the grease reservoir 152. By displacing the displaceable part 104 toward the proximal end relative to the sliding screw shaft 102, the grease supplied into the grease reservoir 152 is guided into the clearance between the nut 138 and the sliding screw shaft 102.

The electric actuator 10A according the present embodiment offers the same advantages and effects as in the case of the electric actuator 10 according to the first embodiment.

The electric actuator 10A according to this embodiment of the invention is not limited to the above structure. In this embodiment, for example, the combination of the sliding screw shaft 102 and the nut 13 shown in Table 1 can be adopted. Further, in the case of forming the DLC film 170 on the threaded part 168 of the nut 138, the DLC film 170 may not be formed on at least part of the intermediate region 168g, and the DLC film 170 may be formed on the first to third starting end portions 168a to 168c and the first to third terminating end portions 168d to 168f. Alternatively, the DLC film 170 may not be formed on the first to third terminating end portions 168d to 168f or the intermediate region 168g, and the DLC film 170 may be formed on the first to third starting end portions 168a to 168c. In this case, it is possible to achieve further reduction of the production cost of the electric actuator 10A.

## Claims

1. An electric actuator (10, 10A) comprising a sliding screw shaft (18, 102), and a nut (52, 138) screw-engaged with the sliding screw shaft (18, 102), the sliding screw shaft (18, 102) being configured to rotate under operation of a motor (12) to thereby cause the nut (52, 138) to be displaced in an axial direction of the sliding screw shaft (18, 102),
wherein the sliding screw shaft (18, 102) is made of light metal or light metal alloy; and
a diamond-like carbon film (60, 170) is formed on a region of a threaded part (58, 168) of the nut (52, 138), the region being located within a range from a starting end of the threaded part (58, 168) of the nut (52, 138) in an axial direction thereof to at least a third thread of the threaded part (58, 168) of the nut (52, 138),
**characterized in that** a thickness of the diamond-like carbon film (60, 170) on a first starting end portion (58a, 168a) of the threaded part (58, 168) of the nut (52, 138) that is located at a first thread from the starting end is larger than a thickness of the diamond-like carbon film (60, 170) on a second starting end portion (58b, 168b) of the threaded part (58, 168) of the nut (52, 138) that is located at a second thread from the starting end.

2. The electric actuator (10, 10A) according to claim 1, wherein the diamond-like carbon film (60, 170) is further formed on a region thereof that is located within a range from a terminating end of the threaded part (58, 168) of the nut (52, 138) in the axial direction to at least a third thread of the threaded part (58, 168) of the nut (52, 138), and
wherein a thickness of the diamond-like carbon film (60, 170) on a first terminating end portion (58d, 168d) of the threaded part (58, 168) of the nut (52, 138) that is located at a first thread from the terminating end is larger than a thickness of the diamond-like carbon film (60, 170) on a second terminating end portion (58e, 168e) of the threaded part (58, 168) of the nut (52, 138) that is located at a second thread from the terminating end.

3. An electric actuator (10, 10A) comprising a sliding screw shaft (18, 102), and a nut (52, 138) screw-engaged with the sliding screw shaft (18, 102), the sliding screw shaft (18, 102) being configured to rotate under operation of a motor (12) to thereby cause the nut (52, 138) to be displaced in an axial direction of the sliding screw shaft (18, 102),
wherein the sliding screw shaft (18, 102) is made of light metal or light metal alloy; and
a diamond-like carbon film (60, 170) is formed on a region of a threaded part (58, 168) of the nut (52, 138), the region being located within a range from a starting end to a terminating end of the threaded part (58, 168) of the nut (52, 138) in an axial direction thereof,
**characterized in that** a thickness of the diamond-like carbon film (60, 170) on a region of the threaded part (58, 168) of the nut (52, 138) that is located within a range from the starting end to the third thread and on a region thereof that is located within a range from the terminating end to the third thread is larger than a thickness of the diamond-like carbon film (60, 170) on an intermediate region (58g, 168g) of the threaded part (58, 168) of the nut (52, 138), the intermediate region (58g, 168g) being located within a range from a fourth thread from the starting end to a fourth thread from the terminating end.

4. An electric actuator (10, 10A) comprising a sliding screw shaft (18, 102), and a nut (52, 138) screw-engaged with the sliding screw shaft (18, 102), the sliding screw shaft (18, 102) being configured to rotate under operation of a motor (12) to thereby cause the nut (52, 138) to be displaced in an axial direction of the sliding screw shaft (18, 102),
wherein the sliding screw shaft (18, 102) is made of light metal or light metal alloy; and
a diamond-like carbon film (60, 170) is formed on a region of a threaded part (58, 168) of the nut (52, 138), the region being located within a range from a starting end of the threaded part (58, 168) of the nut (52, 138) in an axial direction thereof to at least a third thread of the threaded part (58, 168) of the nut (52, 138),
**characterized in that** the diamond-like carbon film (60, 170) is not formed on at least part of an intermediate region (58g, 168g) of the threaded part (58, 168) of the nut (52, 138) that is located within a range from a fourth thread from the starting end to a fourth thread from the terminating end.

5. The electric actuator (10, 10A) according to any one of the preceding claims, wherein a further diamond-like carbon film (50, 130) is formed on the threaded part (48, 128) of the sliding screw shaft (18, 102).

6. The electric actuator (10, 10A) according to claim any one of claims 1 to 4, wherein the sliding screw shaft (18, 102) is made of aluminum or aluminum alloy;
an alumite film is formed on the threaded part (48, 128) of the sliding screw shaft (18, 102).

7. The electric actuator (10, 10A) according to any one of the preceding claims, wherein the nut (52, 138) is made of light metal or light metal alloy.

8. The electric actuator (10, 10A) according to any one of the preceding claims, wherein a thickness of the diamond-like carbon film (60, 170) is 0.1 µm or more and 6.0 µm or less.

9. The electric actuator (10A) according to any one of the preceding claims, wherein the sliding screw shaft (102) includes clearance space (172), and crests (171) of the threaded part (168) of the nut (138) are placed in the clearance space (172) in a state where the crests (171) and the sliding screw shaft (102) do not contact each other.

10. The electric actuator (10A) according to claim 9, wherein the clearance space (172) is configured to store lubricant.

11. The electric actuator (10, 10A) according to claim 5, wherein a thickness of the further diamond-like carbon film (50, 130), which is formed on the threaded part (48, 128) of the sliding screw shaft (18, 102), is 0.1 µm or more and 6.0 µm or less.

## Patentansprüche

1. Ein elektrisches Stellglied (10, 10a) mit einer Gleitspindelwelle (18, 102) und einer Mutter (52, 138), die auf die Gleitspindelwelle (18, 102) geschraubt ist, wobei die Gleitspindelwelle (18, 102) dazu ausgestaltet ist, sich durch Betätigung eines Motors (12) zu drehen, um dadurch eine Verschiebung der Mutter (52, 138) in einer axialen Richtung der Gleitspindelwelle (18, 102) zu bewirken,
wobei die Gleitspindelwelle (18, 102) aus einem Leichtmetall oder einer Leichtmetalllegierung hergestellt ist, und
wobei ein diamantähnlicher Kohlenstofffilm (60, 170) auf einem Bereich eines Gewindeabschnitts (58, 168) der Mutter (52, 138) ausgebildet ist, wobei der Bereich innerhalb eines Bereiches von einem vorderen Ende des Gewindeabschnitts (58, 168) der Mutter (52, 138) in deren axialer Richtung bis zu wenigstens einem dritten Gewindegang des Gewindeabschnitts (58, 168) der Mutter (52, 138) angeordnet ist,
**dadurch gekennzeichnet, dass** eine Dicke des diamantartigen Kohlenstofffilms (60, 170) an einem ersten vorderen Endabschnitt (58, 168a) des Gewindeabschnitts (58, 168) der Mutter (52, 138), der von dem vorderen Ende gesehen an einem ersten Gewindegang angeordnet ist, größer ist als eine Dicke des diamantähnlichen Kohlenstofffilms (60, 170) an einem zweiten vorderen Endabschnitt (58b ,168b) des Gewindeabschnitts (58, 168) der Mutter (52, 138), der von dem vorderen Ende gesehen an einem zweiten Gewindegang angeordnet ist.

2. Das elektrische Stellglied (10, 10a) nach Anspruch 1, wobei der diamantähnliche Kohlenstofffilm (60, 170) außerdem in einem Bereich ausgebildet ist, der in einem Bereich von einem hinteren Ende des Gewindeabschnitts (58, 168) der Mutter (52, 138) in der axialen Richtung bis zu wenigstens einem dritten Gewindegang des Gewindeabschnitts (58, 168) der Mutter (52, 138) angeordnet ist, und
wobei eine Dicke des diamantähnlichen Kohlenstofffilm (60, 170) an einem ersten Endabschnitt (58d, 168d) des Gewindeabschnitts (58, 138) der Mutter (52, 138), der von dem Ende gesehen an einem ersten Gewindegang angeordnet ist, größer ist als eine Dicke des diamantähnlichen Kohlenstofffilms (60, 170) an einem zweiten Endabschnitt (58e, 168e) des Gewindeabschnitts (58, 168) der Mutter (52, 138), der von dem Ende gesehen an einem zweiten Gewindegang angeordnet ist.

3. Ein elektrisches Stellglied (10, 10a) mit einer Gleitspindelwelle (18, 102) und einer Mutter (52, 138), die auf die Gleitspindelwelle (18, 102) geschraubt ist, wobei die Gleitspindelwelle (18, 102) dazu ausgestaltet ist, sich durch Betätigung eines Motors (12) zu drehen, um dadurch die Mutter (52, 138) in einer axialen Richtung der Gleitspindelwelle (18, 102) zu verschieben,
wobei die Gleitspindelwelle (18, 102) aus einem Leichtmetall oder einer Leichtmetalllegierung hergestellt ist, und
wobei ein diamantähnlicher Kohlenstofffilm (60, 170) an einem Bereich eines Gewindeabschnitts (58, 168) der Mutter (52, 238) ausgebildet ist, wobei dieser Bereich in einem Bereich von einem vorderen Ende bis zu einem hinteren Ende des Gewindeabschnitts (58, 168) der Mutter (52, 138) in dessen axialer Richtung angeordnet ist,
**dadurch gekennzeichnet, dass** eine Dicke des diamantähnlichen Kohlenstofffilms (60, 170) in einem Bereich des Gewindeabschnitts (58, 168) der Mutter (52, 138), der innerhalb eines Bereichs von dem vorderen Ende bis zu dem dritten Gewindegang und in einem Bereich, der in einem Bereich von dem hinteren Ende bis zu dem dritten Gewindegang angeordnet ist, größer ist als eine Dicke des diamantähnlichen Kohlenstofffilms (60, 170) in einem mittleren Bereich (58g, 168g) des Gewindeabschnitts (58, 168) der Mutter (52, 138), wobei der mittlere Bereich (158g, 168g) von dem vorderen Ende gesehen in einem Bereich von einem vierten Gewindegang bis zu einem von dem hinteren Ende gesehen vierten Gewindegang angeordnet ist.

4. Ein elektrisches Stellglied (10, 10a) mit einer Gleitspindelwelle (18, 102) und einer Mutter (52, 138), die auf die Gleitspindelwelle (18, 102) geschraubt ist, wobei die Gleitspindelwelle (18, 102) dazu ausgestaltet ist, sich durch Betätigen eines Motors (12) zu drehen, um dadurch die Mutter (52, 138) in einer axialen Richtung der Gleitspindelwelle (18, 102) zu verschieben,
wobei die Gleitspindelwelle (18, 102) aus einem Leichtmetall oder einer Leichtmetalllegierung hergestellt ist, und
wobei ein diamantähnlicher Kohlenstofffilm (60, 170) in einem Bereich eines Gewindeabschnitts (58, 168) der Mutter (52, 138) ausgebildet ist, wobei dieser Bereich in einem Bereich von einem vorderen Ende des Gewindeabschnitts (58, 168) der Mutter (52, 138) in dessen axialer Richtung bis zu wenigstens einem dritten Gewindegang des Gewindeabschnitts (58, 168) der Mutter (52, 138) abgeordnet ist,
**dadurch gekennzeichnet, dass** der diamantähnliche Kohlenstofffilm (60, 170) an wenigstens einem Teil eines mittleren Bereichs (58g, 158g) des Gewindeabschnitts (58, 168) der Mutter (52, 138) nicht ausgebildet ist, der von dem vorderen Ende gesehen in einem Bereich von einem vierten Gewindegang aus bis zu einem von dem hinteren Ende gesehen vierten Gewindegang angeordnet ist.

5. Das elektrische Stellglied (10, 10a) nach einem der vorhergehenden Ansprüche, wobei ein weiterer diamantähnlicher Kohlenstofffilm (50, 130) auf dem Gewindeabschnitt (48, 128) der Gleitspindelwelle (18, 102) ausgebildet ist.

6. Das elektrische Stellglied (10, 10a) nach einem der Ansprüche 1 bis 4, wobei die Gleitspindelwelle (18, 102) aus Aluminium oder einer Aluminiumlegierung hergestellt ist, wobei ein Alumitfilm auf dem Gewindeabschnitt (48, 128) der Gleitspindelwelle (18, 102) ausgebildet ist.

7. Das elektrische Stellglied (10, 10a) nach einem der vorhergehenden Ansprüche, wobei die Mutter (52, 138) aus einem Leichtmetall oder einer Leichtmetalllegierung hergestellt ist.

8. Das elektrische Stellglied (10, 10a) nach einem der vorhergehenden Ansprüche, wobei eine Dicke des diamantähnlichen Kohlenstofffilms (60, 170) 0,1 µm oder mehr und 6,0 µm oder weniger beträgt.

9. Das elektrische Stellglied (10a) nach einem der vorhergehenden Ansprüche, wobei die Gleitspindelwelle (102) einen Freiraum (172) aufweist und wobei Kämme (171) des Gewindeabschnitts (168) der Motor (138) in dem Freiraum (172) in einem Zustand angeordnet sind, in dem die Kämme (171) und die Gleitspindelwelle (102) nicht in Kontakt miteinander stehen.

10. Das elektrische Stellglied (10a) nach Anspruch 9, wobei der Freiraum (152) dazu ausgestaltet ist, ein Schmiermittel aufzunehmen.

11. Das elektrische Stellglied (10, 10a) nach Anspruch 5, wobei eine Dicke des weiteren diamantähnlichen Kohlenstofffilms (50, 130), der auf dem Gewindeabschnitt (58, 128) der Gleitspindelwelle (18, 102) ausgebildet ist, 0,1 µm oder mehr und 6,0µm oder weniger beträgt.

## Revendications

1. Actionneur électrique (10, 10A) comprenant un axe de vis coulissant (18, 102) et un écrou (52, 138) vissé sur l'axe de vis coulissant (18, 102), l'axe de vis coulissant (18, 102) étant configuré pour tourner sous l'action d'un moteur (12) pour ainsi provoquer un déplacement de l'écrou (52, 138) en direction axiale de l'axe de vis coulissant (18, 102),
dans lequel l'axe de vis coulissant (18, 102) est constitué d'un métal léger ou d'un alliage de métal léger ; et
un film de carbone de type diamant (60, 170) est formé sur une région d'une partie filetée (58, 168) de l'écrou (52, 138), la région étant située dans une plage allant d'une extrémité de départ de la partie filetée (58, 168) de l'écrou (52, 138) en direction axiale correspondante jusqu'à au moins un troisième filet de la partie filetée (58, 168) de l'écrou (52, 138),
**caractérisé en ce que** l'épaisseur du film de carbone de type diamant (60, 170) sur une première portion d'extrémité de départ (58a, 168a) de la partie filetée (58, 168) de l'écrou (52, 138) qui est située sur un premier filet depuis l'extrémité de départ est supérieure à l'épaisseur du film de carbone de type diamant (60, 170) sur une deuxième portion d'extrémité de départ (58b, 168b) de la partie filetée (58, 168) de l'écrou (52, 138) qui est située sur un deuxième filet depuis l'extrémité de départ.

2. Actionneur électrique (10, 10A) selon la revendication 1,
dans lequel le film de carbone de type diamant (60, 170) est en outre formé sur une région correspondante située dans une plage allant d'une extrémité terminale de la partie filetée (58, 168) de l'écrou (52, 138) en direction axiale jusqu'à au moins un troisième filet de la partie filetée (58, 168) de l'écrou (52, 138), et
dans lequel l'épaisseur du film de carbone de type diamant (60, 170) sur une première portion d'extrémité terminale (58d, 168d) de la partie filetée (58, 168) de l'écrou (52, 138) qui est située sur un premier filet depuis l'extrémité terminale est supérieure à l'épaisseur du film de carbone de type diamant (60, 170) sur une deuxième portion d'extrémité terminale (58e, 168e) de la partie filetée (58, 168) de l'écrou (52, 138) qui est située sur un deuxième filet depuis l'extrémité terminale.

3. Actionneur électrique (10, 10A) comprenant un axe de vis coulissant (18, 102) et un écrou (52, 138) vissé sur l'axe de vis coulissant (18, 102), l'axe de vis coulissant (18, 102) étant configuré pour tourner sous l'action d'un moteur (12) pour provoquer ainsi un déplacement de l'écrou (52, 138) en direction axiale de l'axe de vis coulissant (18, 102),
dans lequel l'axe de vis coulissant (18, 102) est constitué d'un métal léger ou d'un alliage de métal léger ; et
un film de carbone de type diamant (60, 170) est formé sur une région d'une partie filetée (58, 168) de l'écrou (52, 138), la région étant située dans une plage allant d'une extrémité de départ jusqu'à une extrémité terminale de la partie filetée (58, 168) de l'écrou (52, 138) en direction axiale correspondante, **caractérisé en ce que** l'épaisseur du film de carbone de type diamant (60, 170) sur une région de la partie filetée (58, 168) de l'écrou (52, 138) qui est située dans une plage allant de l'extrémité de départ jusqu'au troisième filet et une région correspondante située dans une plage allant de l'extrémité terminale jusqu'au troisième filet est supérieure à l'épaisseur du film de carbone de type diamant (60, 170) sur une région intermédiaire (58g, 168g) de la partie filetée (58, 168) de l'écrou (52, 138), la région intermédiaire (58g, 168g) étant située dans une plage allant du quatrième filet depuis l'extrémité de départ jusqu'à un quatrième filet depuis l'extrémité terminale.

4. Actionneur électrique (10, 10A) comprenant un axe de vis coulissant (18, 102) et un écrou (52, 138) vissé sur l'axe de vis coulissant (18, 102), l'axe de vis coulissant (18, 102) étant configuré pour tourner sous l'action d'un moteur (12) pour provoquer ainsi un déplacement de l'écrou (52, 138) en direction axiale de l'axe de vis coulissant (18, 102),
dans lequel l'axe de vis coulissant (18, 102) est constitué d'un métal léger ou d'un alliage de métal léger ; et
un film de carbone de type diamant (60, 170) est formé sur une région d'une partie filetée (58, 168) de l'écrou (52, 138), la région étant située dans une plage allant d'une extrémité de départ de la partie filetée (58, 168) de l'écrou (52, 138) en direction axiale correspondante jusqu'à au moins un troisième filet de la partie filetée (58, 168) de l'écrou (52, 138),
**caractérisé en ce que** le film de carbone de type diamant (60, 170) n'est pas formé sur au moins une partie d'une région intermédiaire (58g, 168g) de la partie filetée (58, 168) de l'écrou (52, 138) qui est située dans une plage allant d'un quatrième filet depuis l'extrémité de départ jusqu'à un quatrième filet depuis l'extrémité terminale.

5. Actionneur électrique (10, 10A) selon l'une quelconque des revendications précédentes, dans lequel un autre film de carbone de type diamant (50, 130) est formé sur la partie filetée (48, 128) de l'axe de vis coulissant (18, 102).

6. Actionneur électrique (10, 10A) selon l'une quelconque des revendications 1 à 4, dans lequel
l'axe de vis coulissant (18, 102) est constitué d'aluminium ou d'un alliage d'aluminium ; et
un film d'alumine est formé sur la partie filetée (48, 128) de l'axe de vis coulissant (18, 102).

7. Actionneur électrique (10, 10A) selon l'une quelconque des revendications précédentes, dans lequel l'écrou (52, 138) est constitué d'un métal léger ou d'un alliage de métal léger.

8. Actionneur électrique (10, 10A) selon l'une quelconque des revendications précédentes, dans lequel l'épaisseur du film de carbone de type diamant (60, 170) est supérieure ou égale à 0,1 µm et inférieure ou égale à 6.0 µm.

9. Actionneur électrique (10A) selon l'une quelconque des revendications précédentes, dans lequel l'axe de vis coulissant (102) comprend un espace de dégagement (172), et des crêtes (171) de la partie filetée (168) de l'écrou (138) sont placées dans l'espace de dégagement (172) dans un état où les crêtes (171) et l'axe de vis coulissant (102) ne sont pas en contact entre eux.

10. Actionneur électrique (10A) selon la revendication 9, dans lequel l'espace de dégagement (172) est configuré pour stocker du lubrifiant.

11. Actionneur électrique (10, 10A) selon la revendication 5, dans lequel l'épaisseur dudit autre film de carbone de type diamant (50, 130), qui est formé sur la partie filetée (48, 128) de l'axe de vis coulissant (18, 102), est supérieure ou égale à 0.1 µm et inférieure ou égale à 6.0 µm.
